# EUROPEAN PATENT APPLICATION

(11) **EP 3 751 617 A1**
(43) Date of publication of application: **16.12.2020**
(21) Application number: 20172157.8
(22) Date of filing: 29.04.2020
(51) Int. Cl.: H01L 27/32, H01L 51/52, H01L 51/50

(54) **DISPLAY DEVICE**

(30) Priority: 07.05.2019 KR 20190052809
(71) Applicant: Samsung Display Co., Ltd., Gyeonggi-Do (KR)
(72) Inventor: KIM, Sungwook, Hwaseong-si (KR); KIM, Kyungsik, Suwon-si (KR); KIM, Seulong, Hwaseong-si (KR); NAIJO, Tsuyoshi, Suwon-si (KR); BAE, Sung-Soo, Seoul (KR); LEE, Dongchan, Sejong-si (KR); JEONG, Hyein, Suwon-si (KR); CHOI, Hyewon, Suwon-si (KR); CHU, Seung-Jin, Gwangmyeong-si (KR); HUR, Jaeweon, Seoul (KR)
(74) Representative: Shearman, James Ward

(57) **Abstract**

A display device includes a luminescence element layer to emit a first color light, and a light control layer on the luminescence element layer. The light control layer includes a first light control part including a first luminescence material to emit a second color light in a shorter wavelength range than the first color light, a second light control part to transmit the first color light, and a third light control part including a second luminescence material to emit a third color light in a longer wavelength range than the first color light, and accordingly, a long life-time of the display device may be achieved.

## Description

### BACKGROUND

Display devices including self-luminescence elements are being actively developed as image display devices. Unlike a liquid crystal display device, a display device including a self-luminescence element is a display device in which holes and electrons injected from a first electrode and a second electrode, respectively, recombine in an emission layer, where an organic material or an inorganic material contained in the emission layer is configured to emit light to generate an image. Various studies have been conducted to improve the life-time of display devices.

### SUMMARY

One or more aspects of embodiments of the present disclosure are directed toward a display device having a long life-time and/or high efficiency.

One or more example embodiments of the present disclosure provide a display device including: a luminescence element layer; and a light control layer. The luminescence element layer may be to emit a first color light. The light control layer may be disposed on the luminescence element layer. The light control layer may include a first light control part, a second light control part, and a third light control part. The first light control part may include a first luminescence material to emit a second color light in a shorter wavelength range (light with a shorter wavelength) than the first color light. The second light control part may be to transmit the first color light. The third light control part may include a second luminescence material to emit third color light in a longer wavelength range (light with a longer wavelength) than the first color light. The first to third light control parts may be spaced apart from each other in a plan view.

In an embodiment, the first color light may be green light having a center wavelength of 500 nm to 580 nm. The second color light may be blue light having a center wavelength of 420 nm to 480 nm. The third color light may be red light having a central wavelength of 600 nm to 670 nm.

In an embodiment, the first light control part may further include a luminescence auxiliary material. The luminescence auxiliary material may be to absorb the first color light, to be excited, and to transfer energy to the first luminescence material.

In an embodiment, a first lowest triplet energy level of the first luminescence material may be greater than 1.2 eV and less than a second lowest triplet energy level of the luminescence auxiliary material. The second lowest triplet energy level may be 2.5 eV or less.

In an embodiment, a lowest singlet energy level of the first luminescence material may be 2.5 eV to 3.1 eV.

In an embodiment, the first luminescence material may be a fluorescence material. The luminescence auxiliary material may be a phosphorescence material or a thermally activated delayed fluorescence material.

In an embodiment, the first luminescence material may be an anthracene derivative. The luminescence auxiliary material may be a porphyrin-metal complex.

In an embodiment, the first luminescence material may be a quantum dot. The second luminescence material may be a quantum dot.

In an embodiment, the display device may further include a color filter layer. The color filter layer may be disposed on the light control layer. The color filter layer may include a first color filter, a second color filter, and a third color filter. The first color filter may overlap the first light control part and be to transmit the second color light. The second color filter may overlap the second light control part and be to transmit the first color light. The third color filter may overlap the third light control part and be to transmit the third color light.

In an embodiment, the luminescence element layer may include a luminescence element. The luminescence element may include a first electrode, a second electrode, and at least one emission part. The at least one emission part may be disposed between the first electrode and the second electrode. The at least one emission part may include a hole transport region, an emission layer, and an electron transport region. The emission layer may be disposed on the hole transport region. The electron transport region may be disposed on the emission layer. The emission layer may include a host and a dopant. The dopant may include a phosphorescence dopant, a fluorescence dopant, and/or a thermally activated delayed fluorescence dopant. The emission layer may be to emit phosphorescent light.

In an embodiment, the at least one emission part may include a plurality of emission parts sequentially stacked. The luminescence element may further include a charge generation layer. The charge generation layer may be disposed between the plurality of emission parts.

One or more example embodiments of the present disclosure provide a display device including a display panel including a display area and a non-display area. In the display area, a blue emission area, a green emission area, and a red emission area may be defined. The non-display area may be adjacent to the display area. The display panel may include a luminescence element layer and a light control layer. The luminescence element layer may be to emit green light. The light control layer may be disposed on the luminescence element layer. The light control layer may include a first light control part, a second light control part, and a third light control part. The first light control part may overlap the blue emission area and be to absorb green light and emit blue light. The second light control part may overlap the green emission area and be to transmit green light. The third light control part may overlap the red emission area and be to absorb green light and emit red light.

In an embodiment, the first light control part may include a first luminescence material and a luminescence auxiliary material. A first lowest triplet energy level of the first luminescence material may be greater than 1.2 eV and less than a second lowest triplet energy level of the luminescence auxiliary material. The second lowest triplet energy level of the luminescence auxiliary material may be 2.5 eV or less.

An embodiment of the present disclosure provides a display device including a luminescence element layer and a light control layer. The luminescence element layer may include a plurality of luminescence elements. The light control layer may be disposed on the luminescence element layer. Each of the luminescence elements may include a first electrode, a second electrode, and at least one emission part. The second electrode may be disposed on the first electrode. The at least one emission part may be disposed between the first electrode and the second electrode.

In an embodiment, the at least one emission part may include a hole transport region, an emission layer, and an electron transport region. The emission layer may be disposed on the hole transport region and be to emit green light. The electron transport region may be disposed on the emission layer. The light control layer may include a first light control part, a second light control part, and a third light control part. The first light control part may be to absorb the green light and emit blue light. The second light control part may be to transmit the green light. The third light control part may be to absorb the green light and emit red light. The luminescence element layer may include a first emission part, a second emission part, and a charge generation layer. The second emission part may be disposed on the first emission part. The charge generation layer may be disposed between the first emission part and the second emission part.

In an embodiment, the first light control part may include a first luminescence material and a luminescence auxiliary material. A first lowest triplet energy level of the first luminescence material may be greater than 1.2 eV. A second lowest triplet energy level of the luminescence auxiliary material may be greater than the first lowest triplet energy level of the first luminescence material and may be 2.5 eV or less.

In an embodiment, the first luminescence material may be represented by Formula 1:

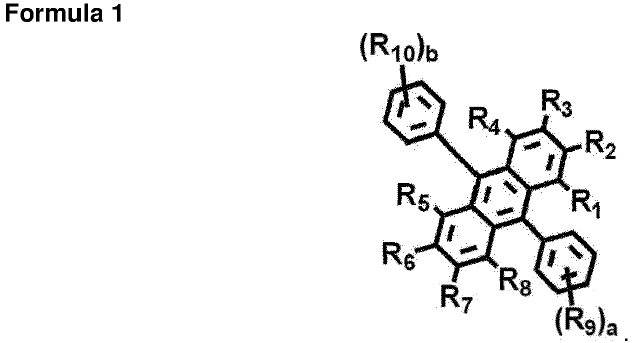

In Formula 1, R₁ to R₁₀ are each independently a hydrogen atom, a deuterium atom, a halogen atom, a substituted or unsubstituted silyl group, a substituted or unsubstituted alkyl group having 1 to 50 carbon atoms, a substituted or unsubstituted aryl group having 6 to 50 ring-forming carbon atoms, or a substituted or unsubstituted heteroaryl group having 2 to 50 ring-forming carbon atoms, or may be bonded to adjacent groups to form a ring. a and b are each independently an integer of 0 to 5.

At least some of the above and other features of the invention are set out in the claims.

### BRIEF DESCRIPTION OF THE FIGURES

The accompanying drawings are included to provide a further understanding of the present disclosure, and are incorporated in and constitute a part of this specification. The drawings illustrate example embodiments of the present disclosure and, together with the description, serve to explain principles of the present disclosure. In the drawings:
FIG. 1 is a perspective view of a display device according to an embodiment;
FIG. 2 is an exploded perspective view of a display device according to an embodiment;
FIG. 3 is a cross-sectional view of a display panel according to an embodiment;
FIG. 4 is a plan view of a display panel according to an embodiment;
FIG. 5 is a cross-sectional view of a display panel taken along a line I-I' in FIG. 4;
FIGS. 6A and 6B are cross-sectional views of a luminescence element according to an embodiment, respectively;
FIGS. 7A and 7B are enlarged cross-sectional views in which a light control layer according to an embodiment is enlarged, respectively;
FIGS. 8A and 8B are views schematically illustrating energy transfer of a first luminescence material and a luminescence auxiliary material which are included in a display device according to an embodiment;
FIG. 9 is a cross-sectional view of a display panel according to an embodiment;
FIG. 10 is a cross-sectional view of a luminescence element according to an embodiment; and
FIGS. 11 and 12 are cross-sectional views of a display panel according to an embodiment, respectively.

### DETAILED DESCRIPTION

It will be understood that when an element (or region, layer, portion, etc.) is referred to as being "on", "connected to" or "coupled to" another element, it can be directly on, connected or coupled to the other element or layer or intervening elements may also be present.

Like numbers refer to like elements throughout, and redundant descriptions thereof may be omitted. The thickness and the ratio and the dimension of the element may be exaggerated for effective description of the technical contents.

The term "and/or" includes any and all combinations of one or more of the associated listed items.

The terms "first" and "second" may be used to describe various elements, however, the elements should not be limited by these terms. These terms are merely used for the purpose of discriminating one element from another element. For example, the first element may be designated as the second element, and similarly, the second element may also be designated as the first element, without departing from the spirit or scope of the present disclosure. Singular forms, otherwise indicated, include plural forms.

Further, the terms "under", "below", "on", "above", and/or the like, may be used herein for ease of description to describe one element or feature's relationship to another element(s) or feature(s) as illustrated in the figures. It will be understood that the terms are relative concepts, and may be described on the basis of the direction illustrated in the figures.

Unless otherwise defined, all terms (including technical and scientific terms) used herein will have the meanings that are generally understood by a person skilled in the art. It will be further understood that terms commonly defined in the dictionary should be considered to have the contextual meaning of the related art, unless expressly defined herein to have particular or non-standard meaning. The terms "fluorescence," "phosphorescence," and "luminescence" may refer to the state of being fluorescent, phosphorescent, and luminescent, respectively, as understood from the context.

In the description, it should be understood that the term "comprise" or "have" indicates that the specified features, numerals, steps, operations, elements, parts, or combinations thereof, do not exclude the possible presence or addition of other features, numerals, steps, operations, elements, parts, or combinations thereof.

Hereinafter, embodiments of the present disclosure will be described with reference to the drawings.

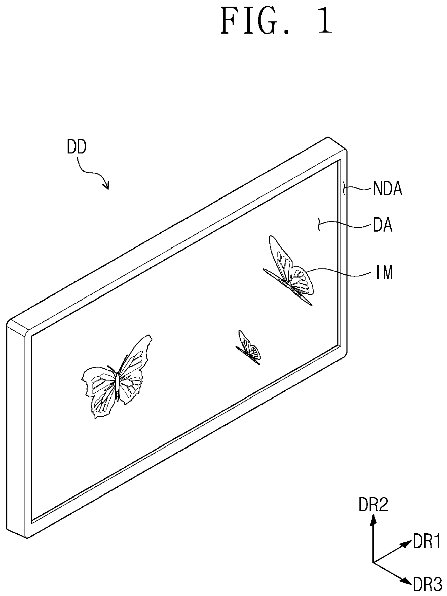

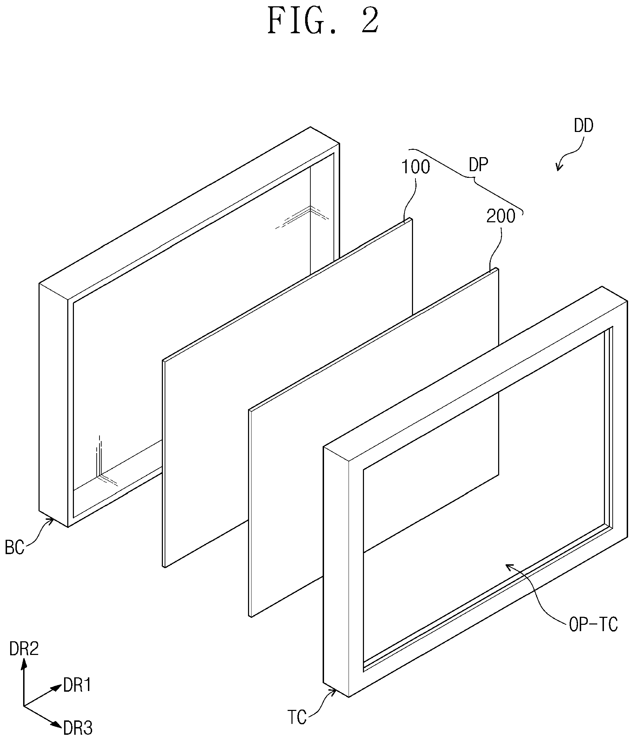

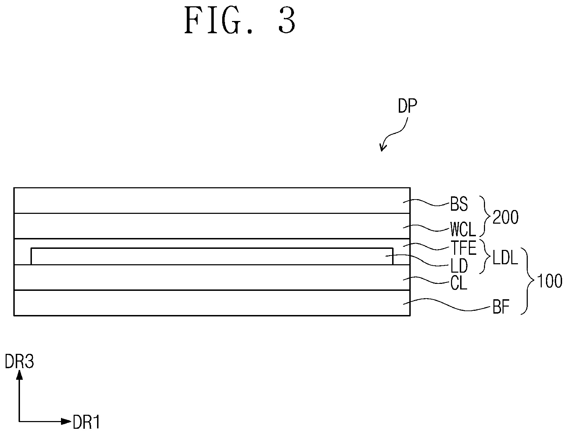

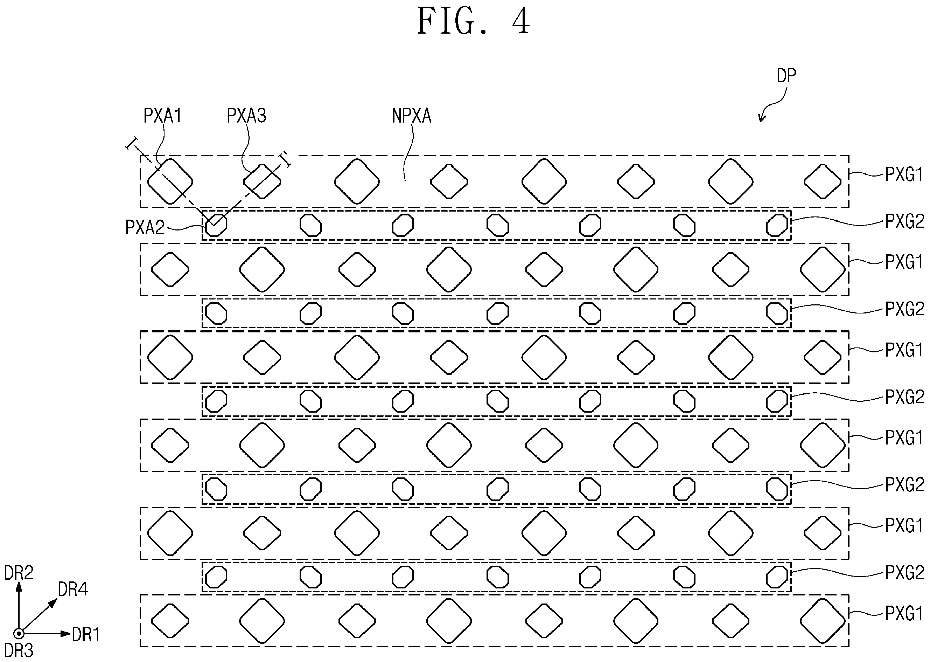

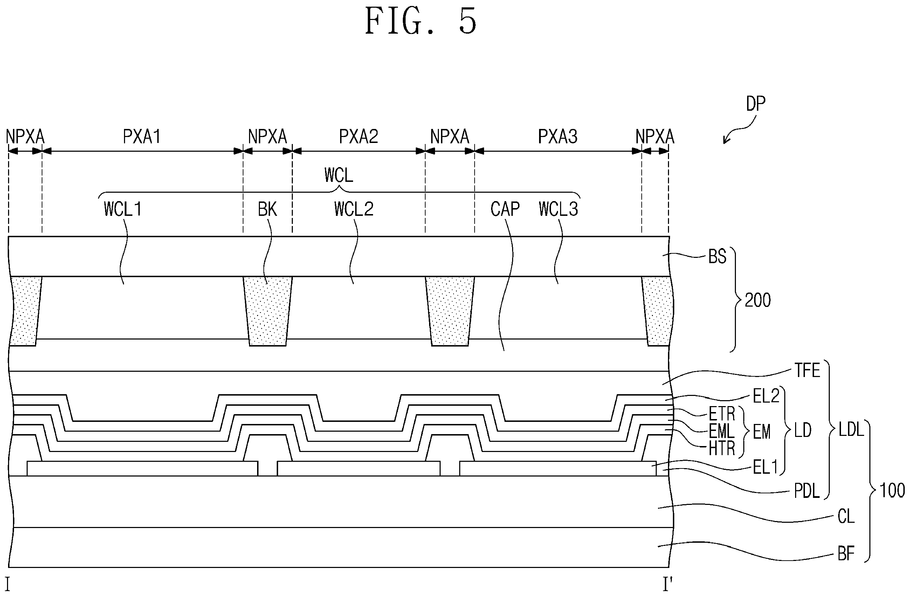

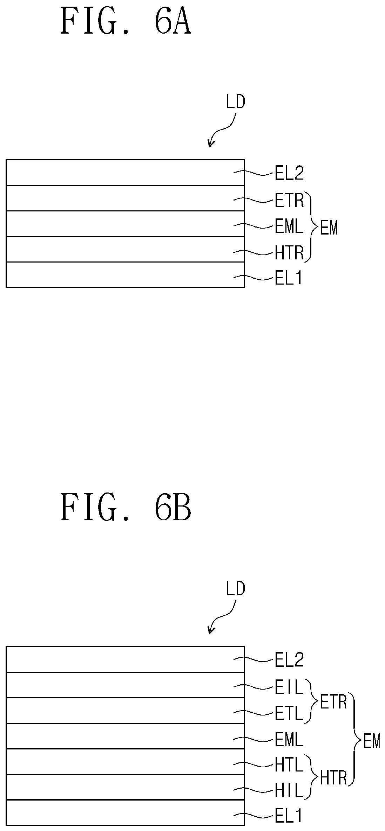

FIG. 1 is a perspective view of a display device DD according to an embodiment. FIG. 2 is an exploded perspective view of a display device DD according to an embodiment. FIG. 3 is a cross-sectional view of a display panel DP according to embodiment. FIG. 4 is a plan view of a display panel DP according to embodiment. FIG. 5 is a cross-sectional view of a display panel DP taken along a line I-I' in FIG. 4. FIGS. 6A and 6B are cross-sectional views of a luminescence element LD according to an embodiment, respectively.

Referring to FIG. 1, a display area DA and a non-display area NDA may be defined in the display device DD. The display area DA may be an area in which an image IM is displayed. In FIG. 1, a butterfly is illustrated as an example of the image IM. The non-display area NDA may be an area in which an image IM is not displayed. Pixels may be disposed in the display area DA, and pixels may not be disposed (e.g., may not be included) in the non-display area NDA. As used herein, the term "pixels" may refer to pixels for effectively providing an image IM.

The display area DA is parallel to a plane defined by a first directional axis DR1 and a second directional axis DR2. A normal direction of the display area DA, for example, a thickness direction of the display device DD is indicated by (e.g., parallel to) a third directional axis DR3. A front surface (or upper surface) and a back surface (or lower surface) of each of the members are separated in the third directional axis DR3. However, the directions indicated by the first to third directions DR1, DR2, and DR3 are relative concepts, and may be converted into different directions. Hereinafter, the first to third directions refer to the same reference numerals in the directions indicated by the first to third directional axes DR1, DR2, and DR3, respectively.

The display device DD may be used for a large electronic device (such as a television, a monitor, and/or an outdoor billboard), and may also be used for a small or medium electronic device (such as a personal computer, a notebook computer, a personal digital terminal, a car navigation unit, a game machine, a portable electronic device, and/or a camera). These embodiments are presented only as examples, it should be understood that the present disclosure may be embodied in other electronic devices without departing from the concept of the present disclosure.

A bezel area of the display device DD may be defined by the non-display area NDA. The non-display area NDA may be an area adjacent to the display area DA. The non-display area NDA may surround the display area DA. However, embodiments are not limited thereto, and the shape of the display area DA and the shape of the non-display area NDA may be relatively designed. In another embodiment of the present disclosure, the non-display area NDA may be omitted.

Referring to FIG. 2, the display device may include a bottom cover BC, a display panel DP, and a top cover TC. The bottom cover BC may be disposed under the display panel DP to protect the display device DD from external shocks or contaminants.

In another embodiment of the present disclosure, the top cover TC may be omitted. When the display device DD does not include the top cover TC, the non-display area NDA may be defined by a sealing member, a mold, and/or the like.

The top cover TC may protect the display panel DP, etc. from external shocks and/or contaminants. An opening OP-TC of the top cover TC may define the display area DA by exposing a front surface of the display panel DP.

Referring to FIGS. 2 and 3, the display panel DP may include a first display substrate 100 and a second display substrate 200. The second display substrate 200 may be disposed on the first display substrate 100. The first display substrate 100 may include a base film BF, a circuit layer CL, and a luminescence element layer LDL. The second display substrate 200 may include a light control layer WCL and a base substrate BS.

The base film BF may be to provide a base surface on which the circuit layer CL is disposed. The base film BF may be a silicon substrate, a plastic substrate, a glass substrate, a metal substrate, or a laminated structure including a plurality of insulating layers. However, embodiments are not limited thereto, and the base film BF may be an inorganic layer, an organic layer, or a composite layer.

The circuit layer CL may be disposed on the base film BF. The circuit layer CL may include a plurality of transistors. The transistors may each include a control electrode, an input electrode, and an output electrode. For example, the circuit layer CL may include a switching transistor and a driving transistor for driving the luminescence elements LD.

The luminescence element layer LDL may include a plurality of luminescence elements LD and a thin film encapsulation layer TFE. The thin film encapsulation layer TFE may cover the plurality of luminescence elements LD. The thin film encapsulation layer TFE may be disposed directly on the plurality of luminescence elements LD to seal the luminescence elements LD.

The light control layer WCL may be disposed on the thin film encapsulation layer TFE. An adhesive member may be disposed between the light control layer WCL and the thin film encapsulation layer TFE. The adhesive member may adhere (attach) the light control layer WCL and the thin film encapsulation layer TFE. The adhesive member may be, for example, an optically clear adhesive. The light control layer WCL may be to absorb light emitted from the luminescence element layer LDL and to subsequently emit light having a center wavelength in a wavelength range different from the absorbed light, or in some embodiments may be to transmit light emitted from the luminescence element layer LDL. The base substrate BS may serve as a support substrate for supporting the light control layer WCL. The base substrate BS may be a glass substrate and/or a plastic substrate.

Referring to FIGS. 4 and 5, the display panel DP may include a non-emission area NPXA and emission areas PXA1, PXA2, and PXA3. Each of the emission areas PXA1, PXA2, and PXA3 may be an area in which light generated from each of the luminescence elements LD is emitted. The areas of the respective emission areas PXA1, PXA2, and PXA3 may be different from each other, and as used herein, each area may refer to the planar area observed in a plan view. As used herein, "plan view" may correspond to when the display device DD is viewed from above along the third direction DR3 (thickness direction). The emission areas PXA1, PXA2, and PXA3 may be divided into a plurality of groups according to the color of light generated in the luminescence elements LD (in FIG. 4).

In the display panel DP according to an embodiment illustrated in FIGS. 4 and 5, three emission areas PXA1, PXA2, and PXA3 emitting second color light, first color light, and third color light, respectively, are illustrated. For example, the display panel DP according to an embodiment may include a first emission area PXA1, a second emission area PXA2, and a third emission area PXA3 separated from each other.

In an embodiment, the display panel DP may include a plurality of luminescence elements LD that are to emit the first color light, and light control parts WCL1, WCL2, and WCL3 that are to transmit the first color light or to absorb the first color light and subsequently emit light having different wavelength ranges from each other. Each of the light control parts WCL1, WCL2 and WCL3 may transmit the first color light or absorb the first color light to then emit lights of different colors. For example, in an embodiment, the first light control part WCL1 may absorb the first color light to emit the second color light, the second light control part WCL2 may transmit the first color light, and the third light control part WCL3 may absorb the first color light to emit the third color light. The first color light may be light in a longer wavelength range (light with a longer wavelength) than the second color light, and a shorter wavelength range (light with a shorter wavelength) than the third color light. Embodiments are not limited thereto, and in some embodiments, for example, the first color light may be green light, the second color light may be blue light, and the third color light may be red light. For example, the first color light may be green light having a center wavelength of about 500 nm to about 580 nm, the second color light may be blue light having a center wavelength of about 420 nm to about 480 nm, and the third color light may be red light having a center wavelength of about 600 nm to about 670 nm. For example, the first color light may be green light having a center wavelength of about 515 nm to about 545 nm.

Each of the light control parts WCL1, WCL2, and WCL3 may be disposed corresponding to the first emission area PXA1, the second emission area PXA2, and the third emission area PXA3, and may overlap the first emission area PXA1, the second emission area PXA2, and the third emission area PXA3 when seen in a plan view, respectively. For example, the first emission area PXA1 may be a blue-emission area (e.g., an area to emit blue light), the second emission area PXA2 may be a green-emission area (e.g., an area to emit green light), and the third emission area PXA3 may be a red-emission area (e.g., an area to emit red light).

In the display panel DP according to an embodiment illustrated in FIGS. 4 and 5, the emission areas PXA1, PXA2, and PXA3 may have different areas (e.g., planar area sizes) according to the colors of light emitted from the light control parts WCL1, WCL2, and WCL3 of the light control layer WCL. For example, referring to FIGS. 4 and 5, the first emission area PXA1 of the first light control part WCL1 (which is to emit the second color light) may have the largest area, and the second emission area PXA2 of the second light control part WCL2 may have the smallest area. However, embodiments are not limited thereto, and in some embodiments the emission areas PXA1, PXA2, and PXA3 may have the same area, or may be provided at different area ratios (relative planar sizes) from those illustrated in FIGS. 4 and 5.

Each of the emission areas PXA1, PXA2, and PXA3 may be separated by a pixel defining layer PDL. The non-emission areas NPXA may be between the neighboring emission areas PXA1, PXA2, and PXA3, and may correspond to the pixel defining layer PDL. In the present specification, each of the emission areas PXA1, PXA2, and PXA3 may correspond to a pixel.

The pixel defining layer PDL may be formed of a polymer resin. For example, the pixel defining layer PDL may be formed by including a polyacrylate-based resin and/or a polyimide-based resin. Furthermore, the pixel defining layer PDL may be formed by further including an inorganic material in addition to the polymer resin. On the other hand, the pixel defining layer PDL may be formed by including a light absorbing material, and/or by including a black pigment and/or a black dye. The pixel defining layer PDL formed by including the black pigment and/or the black dye may achieve a black pixel defining layer. Carbon black, etc. may be used as the black pigment and/or the black dye during formation of the pixel defining layer PDL, but embodiments are not limited thereto.

For example, the pixel defining layer PDL may be formed of an inorganic material. In some embodiments, the pixel defining layer PDL may be formed by including silicon nitride (SiNₓ), silicon oxide (SiOₓ), silicon oxynitride (SiOₓN_{y}), etc. The pixel defining layer PDL may define the emission areas PXA1, PXA2, and PXA3. The emission areas PXA1, PXA2, and PXA3 and the non-emission area NPXA may be distinguished from each other by the pixel defining layer PDL.

The first emission areas PXA1 and the third emission areas PXA3 may be alternatingly disposed (arranged) along the first directional axis DR1 to constitute a first group PXG1. The second emission areas PXA2 may be arranged (aligned) along the first directional axis DR1 (e.g., along a parallel line) to constitute a second group PXG2.

The first group PXG1 may be disposed (spaced) apart from the second group PXG2 along the second directional axis DR2. Each of the first group PXG1 and the second group PXG2 may be provided in plurality (e.g., multiples). The first groups PXG1 and the second groups PXG2 may be alternatingly arranged along the second directional axis DR2.

One second emission area PXA2 may be disposed apart from one first emission area PXA1 or one third emission area PXA3 in the direction of a fourth directional axis DR4. The direction of the fourth directional axis DR4 may be a diagonal direction between the direction of the first directional axis DR1 and the direction of the second directional axis DR2 (e.g., at an intermediate angle of less than 90 degrees (for example, 45 degrees each) from DR1 and DR2 in the plane formed by DR1 and DR2 in the first Cartesian quadrant, or in some embodiments the second quadrant).

An arrangement structure of the emission areas PXA1, PXA2, and PXA3 illustrated in FIG. 4 may be referred to as a pentile structure. However, the arrangement structure of the emission areas PXA1, PXA2, and PXA3 in the display device DD according to an embodiment is not limited to the arrangement structure illustrated in FIG. 4. For example, in an embodiment, the emission areas PXA1, PXA2, and PXA3, may have a stripe structure along the first directional axis DR1, in which the first emission area PXA1, the second emission area PXA2, and the third emission area PXA3 may be alternatingly arranged.

Referring to FIG. 5, the luminescence element layer LDL may include a plurality of luminescence elements LD. The luminescence elements LD may include a first electrode EL1, a second electrode EL2, and at least one emission part EM. The first electrode EL1 may be disposed on the circuit layer CL. The first electrode EL1 may be electrically connected to a driving transistor to receive a driving signal. The first electrode EL1 may be disposed apart from (e.g., to be distinguishable from) the plurality of pixel defining layers PDL. The second electrode EL2 may be disposed on or above the first electrode EL1. At least one emission part EM may be disposed between the first electrode EL1 and the second electrode EL2. The at least one emission part EM may include a hole transport region HTR, an emission layer EML, and an electron transport region ETR.

FIGS. 6A and 6B are cross-sectional views illustrating the luminescence element LD included in the luminescence element layer LDL, according to an embodiment including an electron transport region ETR between the second electrode EL2 and the emission layer EML, and a hole transport region HTR between the first electrode EL1 and the emission layer EML. FIG. 6B, in comparison with FIG. 6A, is a cross-sectional view of the luminescence element LD according to an embodiment in which the hole transport region HTR includes a hole injection layer HIL and a hole transport layer HTL, and the electron transport region ETR includes an electron injection layer EIL and an electron transport layer ETL.

The first electrode EL1 constituting the luminescence element LD has conductivity (e.g., may be conductive). The first electrode EL1 may be formed of a metal alloy or a conductive compound. The first electrode EL1 may be an anode. The first electrode EL1 may be a pixel electrode. In the luminescence element LD according to an embodiment, the first electrode EL1 may be a reflective electrode. However, embodiments are not limited thereto. For example, the first electrode EL1 may be a transmissive electrode or a transflective electrode. When the first electrode EL1 is a transflective electrode or a reflective electrode, the first electrode EL1 may include silver (Ag), magnesium (Mg), copper (Cu), aluminium (Al), platinum (Pt), palladium (Pd), gold (Au), nickel (Ni), neodymium (Nd), iridium (Ir), chromium (Cr), lithium (Li), calcium (Ca), LiF/Ca, LiF/AI, molybdenum (Mo), titanium (Ti), and/or a compound or a mixture thereof (for example, a mixture of Ag and Mg). For example, the first electrode EL1 may have a structure including a plurality of layers including: a reflective layer or a transflective layer formed of any of the described materials; and a transparent conductive layer formed of indium tin oxide (ITO), indium zinc oxide (IZO), zinc oxide (ZnO), indium tin zinc oxide (ITZO), an/or the like. For example, the first electrode EL1 may be a multi-layer metal film, or may be a structure in which a metal film of ITO/Ag/ITO is laminated.

The hole transport region HTR may have a structure of: a single layer formed of a single material; a single layer formed of a plurality of different materials; or a multi-layer structure having a plurality of layers formed of a plurality of different materials. For example, the hole transport region HTR may have a structure of a single layer formed of a plurality of different materials, or may have a structure of hole injection layer HIL/hole transport layer HTL, hole injection layer HIL/hole transport layer HTL/buffer layer, hole injection layer HIL/buffer layer, hole transport layer HTL/buffer layer, or hole injection layer HIL/hole transport layer HTL/electron blocking layer, wherein the elements of each structure are sequentially laminated from the first electrode EL1 in each stated order, but embodiments are not limited thereto.

For example, the hole transport region HTR may include the hole injection layer HIL and the hole transport layer HTL, and any suitable hole injection materials and hole transport materials may be used for the hole injection layer HIL and the hole transport layer HTL, respectively.

The emission layer EML is disposed on the hole transport region HTR. The emission layer may have a structure of: a single layer formed of a single material; a single layer formed of a plurality of different materials; or a multi-layer having a plurality of layers formed of a plurality of different materials.

The emission layer EML may be to emit a first color light. For example, the emission layer EML may be formed of an organic material configured to emit green light, and may include a fluorescence material and/or a phosphorescence material. For example, the emission layer EML may include a host and a dopant. The dopant may include a phosphorescence dopant, a fluorescence dopant, and/or a thermally activated delayed fluorescence dopant. For example, the emission layer EML may include any one of a phosphorescence dopant, a fluorescence dopant, or a thermally activated delayed fluorescence dopant as a dopant, or may include a thermally activated delayed fluorescence dopant as a first dopant and a fluorescence dopant as a second dopant. For example, the emission layer EML may include a phosphorescence dopant. For example, the emission layer EML may be to emit phosphorescent light.

When the emission layer EML is to emit green light, the emission layer EML may further include a fluorescence material which contains, for example, tris(8-hydroxyquinolino)aluminium (Alq₃). When the emission layer EML is to emit green light, a dopant included in the emission layer EML may be selected from, for example, a metal complex or an organometallic complex (such as fac-tris(2-phenylpyridine)iridium (Ir(ppy)₃), coumarin, and derivatives thereof). The metal complex or the organometallic complex may be selected from the group consisting of iridium (Ir), platinum (Pt), osmium (Os), gold (Au), copper (Cu), rhenium (Re), and ruthenium (Ru). For example, at least one selected from iridium(III) bis(2-phenylquinolyl-N,C2') acetylacetonate (PQIr), fac-tris(2-phenylpyridine)iridium (Ir(ppy)₃), and a compound selected from Compound Group 1 may be included:

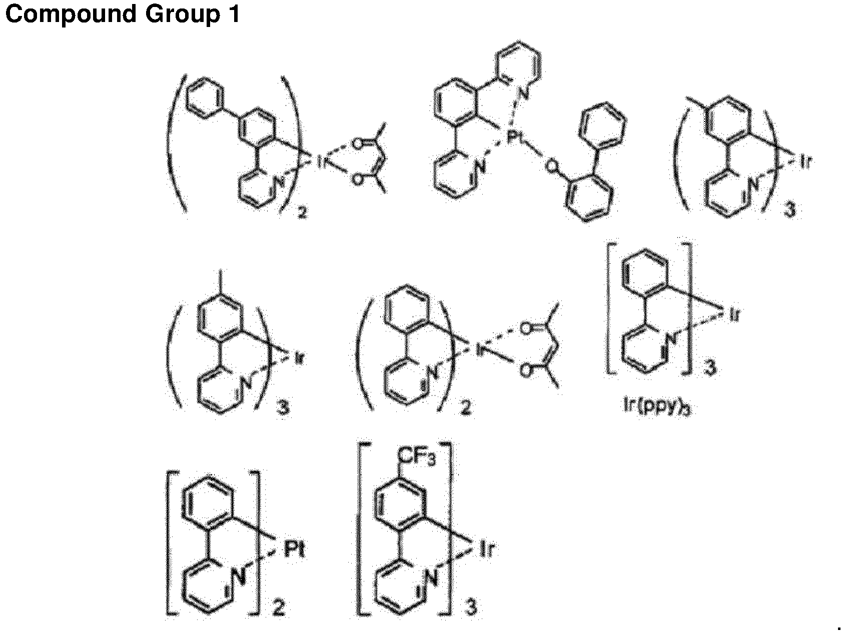

However, the embodiment is merely an example, and the emission layer EML may include any suitable green phosphorescence material available in the art, without limitation.

In the description of the luminescence element LD illustrated in FIGS. 6A and 6B, the emission layer EML includes an organic material, but embodiments are not limited thereto, and the emission layer EML may be a quantum dot emission layer including a quantum dot as a luminescence material. When the emission layer EML includes a quantum dot as a luminescence material, the quantum dot may be substantially the same as the quantum dot QD2 that will be described later.

The electron transport region ETR is disposed on the emission layer EML. The electron transport region ETR may include at least one selected from a hole blocking layer, an electron transport layer ETL, and an electron injection layer EIL, but embodiments are not limited thereto.

When the electron transport region ETR includes the electron injection layer EIL and the electron transport layer ETL, any suitable electron injection materials and electron transport materials may be used for the electron injection layer EIL and the electron transport layer ETL, respectively.

The second electrode EL2 is disposed on the electron transport region ETR. The second electrode EL2 may be a common electrode or a cathode. The second electrode EL2 may be formed of a metal alloy or a conductive compound. The second electrode EL2 may be a transmissive electrode, a transflective electrode, or a reflective electrode. When the second electrode EL2 is a transmissive electrode, the second electrode EL2 may be formed of a transparent metal oxide, for example, indium tin oxide (ITO), indium zinc oxide (IZO), zinc oxide (ZnO), indium tin zinc oxide (ITZO), and/or the like.

When the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, and/or a compound or a mixture thereof (e.g., a mixture of Ag and Mg). For example, the second electrode EL2 may have a structure having a plurality of layers including: a reflective layer or a transflective layer formed of the described materials; and a transparent conductive layer formed of indium tin oxide (ITO), indium zinc oxide (IZO), zinc oxide (ZnO), indium tin zinc oxide (ITZO), and/or the like.

In some embodiments, the second electrode EL2 may be connected to an auxiliary electrode. When the second electrode EL2 is connected to the auxiliary electrode, the resistance of the second electrode EL2 may be reduced.

Among the first electrode EL1 and the second electrode EL2 facing each other in the display panel DP according to an embodiment, the first electrode EL1 may be a reflective electrode and the second electrode EL2 may be a transmissive electrode. In an embodiment, the luminescence element LD may be front surface luminescent (e.g., may emit light through the front or upper surface). However, embodiments are not limited thereto.

In some embodiments, a capping layer may be further disposed on the second electrode EL2. The capping layer may be a layer for adjusting a resonance distance of light emitted from the emission layer EML, or for adjusting the optical characteristics of the luminescence element LD (such as a refractive index).

Referring to FIG. 5 again, each of the hole transport region HTR, the emission layer EML, and the electron transport region ETR, which constitute (are included in) the emission part EM, may be provided as a common layer in all of the plurality of neighboring luminescence elements LD. Unlike the case in which the first electrodes EL1 are patterned and provided on the circuit layer CL in a state of being spaced apart from each other, each of the hole transport region HTR, the emission layer EML, and the electron transport region ETR may not be patterned, and may be positioned to extend over the entire luminescence element layer LDL.

The thin film encapsulation layer TFE may be disposed on the second electrode EL2. In some embodiments, the thin film encapsulation layer TFE may be directly disposed on the second electrode EL2. When the luminescence element LD further includes a capping layer, the thin film encapsulation layer TFE may be directly disposed on the capping layer.

A light control layer WCL may be disposed on the thin film encapsulation layer TFE. The light control layer WCL may include a first light control part WCL1, a second light control part WCL2, a third light control part WCL3, and a partition wall part BK (e.g., a plurality thereof). The partition wall parts BK may be disposed apart from each other on the base substrate BS. The partition wall parts BK may be disposed so as to correspond one-to-one with the arrangement position of the pixel defining layer PDL. The partition wall parts BK may be disposed between the first to third light control parts WCL1, WCL2, and WCL3 to prevent or reduce light emitted from the first to third light control parts WCL1, WCL2, and WCL3 from being mixed.

The first to third light control parts WCL1, WCL2, and WCL3 may be disposed apart from each other in a plan view.

The light control layer WCL may further include a protective layer CAP. The protective layer CAP may be disposed on the first to third light control parts WCL1, WCL2, and WCL3 and the partition wall part BK. The protective layer CAP may serve to prevent or reduce permeation of moisture and/or oxygen (hereinafter, referred to as 'moisture/oxygen'). The protective layer CAP may be disposed on the first to third light control parts WCL1, WCL2, and WCL3 to block the first to third light control parts WCL1, WCL2, and WCL3 from being exposed to moisture/oxygen. The protective layer CAP may include at least one inorganic layer. For example, the protective layer CAP may be formed by including an inorganic material. For example, the protective layer CAP may be formed by including a silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, and/or a metal thin film having ensured light transmittance. On the other hand, the protective layer CAP may further include an organic film. The protective layer CAP may be composed of a single layer or a plurality of layers.

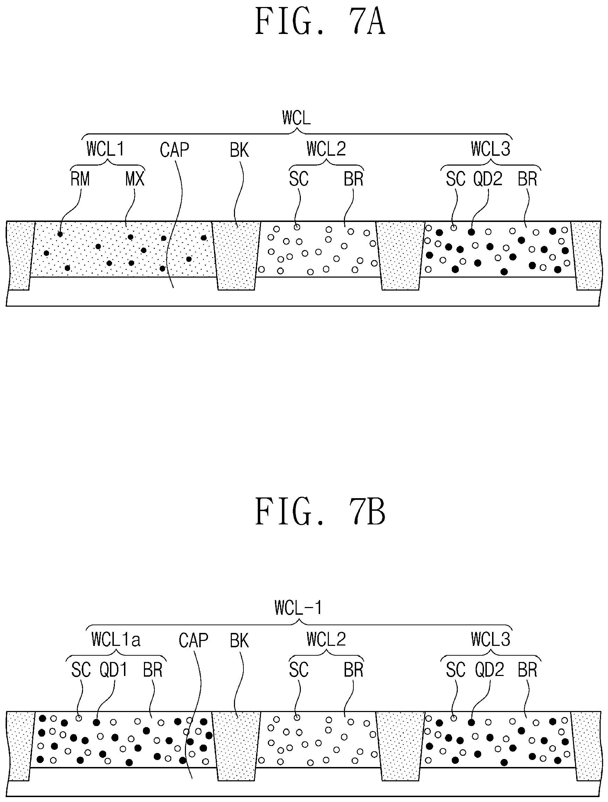

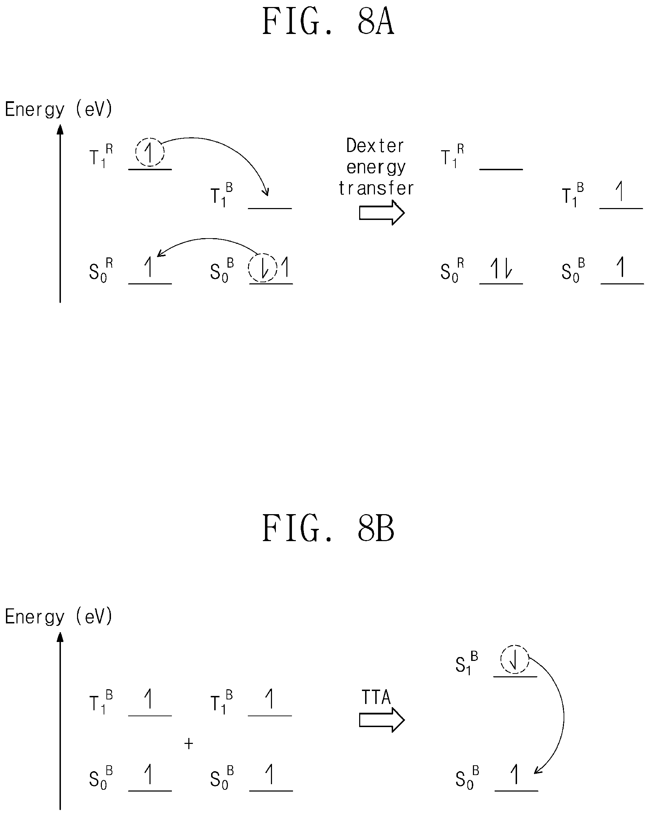

FIGS. 7A and 7B are enlarged cross-sectional views in which the light control layers WCL and WCL-1 according to an embodiment are enlarged, respectively. FIGS. 8A and 8B are views schematically illustrating energy transfer between a first luminescence material RM and a luminescence auxiliary material, which are included in the display device DD according to an embodiment.

Referring to FIG. 7A, the first light control part WCL1 may include the first luminescence material RM. The first luminescence material RM may emit the second color light in the shorter wavelength range than the first color light. The first luminescence material RM may be an organic compound or a quantum dot. The first light control part WCL1 may further include the luminescence auxiliary material.

When the first luminescence material RM is an organic compound, the first light control part WCL1 may further include a luminescence auxiliary material. The luminescence auxiliary material may absorb the first color light and be excited (e.g., be promoted to an excited state), and then may transfer energy to the first luminescence material RM.

Referring to FIG. 8A, the first luminescence material RM and the luminescence auxiliary material exchange energy with each other through a Dexter energy transfer method.

In the present specification, S₀^{R} refers to the energy level of the bottom state (e.g., ground state) of the luminescence auxiliary material, and S₀^{B} refers to the energy level of the bottom state (e.g., ground state) of the first luminescence material RM. T₁^{R} refers to the lowest triplet energy level of the luminescence auxiliary material, and T₁^{B} refers to the lowest triplet energy level of the first luminescence material RM. S₁^{B} refers to the lowest excited singlet energy level of the first luminescence material RM. In the present specification, the lowest triplet energy level (T₁^{B}) of the first luminescence material RM may be referred to as a first lowest triplet energy level (e.g., in the entire system), and the lowest triplet energy level (T₁^{R}) of the luminescence auxiliary material may be referred to as a second lowest triplet energy level (e.g., in the entire system).

The luminescence auxiliary material receives the first color light emitted from the luminescence element LD, and an electron from S₀^{R} is excited to T₁^{R}. Thereafter, the electron in T₁^{R} of the luminescence auxiliary material transfers to T₁^{B} of the first luminescence material RM, and an electron from S₀^{B} of the first luminescence material RM transfers to S₀^{R} of the luminescence auxiliary material.

Referring to FIG. 8B, triplet-triplet annihilation (hereinafter, referred to as TTA) occurs in the first luminescence material RM, and one S₁^{B} state electron may be generated. The electron in the S₁^{B} state falls to the S₀^{B} ground state, and the second color light in a shorter wavelength range (light with a shorter wavelength) than the first color light may be emitted. For example, blue light having a shorter wavelength than green light may be emitted.

The lowest triplet energy level (T₁^{B}) of the first luminescence material RM may be greater than 1.2 eV and less than the lowest triplet energy level (T₁^{R}) of the luminescence auxiliary material. The lowest singlet energy level (S₁^{B}) of the first luminescence material RM may be about 2.5 eV to about 3.1 eV. For example, the first luminescence material RM may be a blue fluorescence material.

The lowest triplet energy level (T₁^{R}) of the luminescence auxiliary material may be 2.5 eV or less. When the lowest triplet energy level (T₁^{R}) of the luminescence auxiliary material is 2.5 eV or less, the electron in the ground state may be excited to the lowest triplet energy level (T₁^{R}) or the lowest singlet energy level by absorbing green light emitted from the luminescence element.

When the lowest triplet energy level (T₁^{B}) of the first luminescence material RM is smaller (lower) than the lowest triplet energy level (T₁^{R}) of the luminescence auxiliary material, the electron in T₁^{R} of the luminescence auxiliary material may move to T₁^{B} of the first luminescence material RM.

When the lowest triplet energy level (T₁^{B}) of the first luminescence material RM is larger than 1.2 eV, TTA may occur and a singlet having an energy level of 2.7 eV to 3.0 eV may be generated. Accordingly, blue light emission may be possible.

The first light control part WCL1 may include the first luminescence material RM and the luminescence auxiliary material in a state of being dispersed in a matrix part MX. For example, the first light control part WCL1 may include the first luminescence material RM and the luminescence auxiliary material in a form of a film mixed with a polymer resin such as poly(methyl methacrylate) (PMMA). However, embodiments are not limited thereto, and the matrix part MX may be an organic compound, not a polymer resin. For example, the first light control part WCL1 may include the first luminescence material RM and the luminescence auxiliary material mixed with an organic compound (such as 1,2-dichloroethane) provided in a gel form or state.

When the matrix part MX is a polymer resin, substantially the same description as the base resin BR in the first light control part WCL1 and the second light control part WCL2 (described below) may be applied.

With respect to the total weight (100 wt%) of the first luminescence material RM and the luminescence auxiliary material, the first luminescence material RM may have a ratio (amount) of about 70 wt% or more and 99 wt% or less, and the luminescence auxiliary material may have a ratio (amount) of about 1 wt% or more and 30 wt% or less. When the ratio (relative amounts) of the first luminescence material RM and the luminescence auxiliary material satisfies the described range, the first light control part WCL1 may achieve satisfactory light conversion efficiency.

In some embodiments, the first luminescence material RM may be a blue fluorescence material. For example, the first luminescence material RM may be an anthracene derivative, a pyrene derivative, a fluoranthene derivative, a chrysene derivative, a dihydrobenzanthracene derivative, or a triphenylene derivative.

When the first luminescence material RM is an anthracene derivative, for example, the anthracene derivative may be represented by Formula 1:

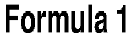

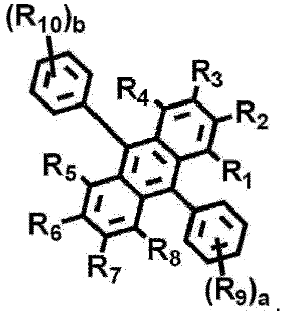

In Formula 1, R₁ to R₁₀ are each independently a hydrogen atom, a deuterium atom, a halogen atom, a substituted or unsubstituted silyl group, a substituted or unsubstituted alkyl group having 1 to 50 (*e.g.* 1 to 10) carbon atoms, a substituted or unsubstituted aryl group having 6 to 50 (*e.g.* 6 to 20) ring-forming carbon atoms, or a substituted or unsubstituted heteroaryl group having 2 to 50 (*e.g.* 2 to 20) ring-forming carbon atoms, or may be bonded to an adjacent group (*e.g*. adjacent groups) to form a ring.

In the present description, the term "substituted or unsubstituted" corresponds to: substituted with at least one substituent selected from the group consisting of a deuterium atom, a halogen atom, a cyano group, a nitro group, an amino group, a silyl group, a boron group, a phosphine oxide group, a phosphine sulfide group, an alkyl group, an alkenyl group, an aryl group, and a heterocyclic group; or unsubstituted. In addition, each of the substituents exemplified above may be substituted or unsubstituted. For example, a biphenyl group may be interpreted as an aryl group or a phenyl group substituted with a phenyl group.

In the present description, the alkyl group may be a linear, branched, or cyclic type (e.g., a linear, branched, or cyclic alkyl group). The carbon number of the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a cyclopentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, a cyclohexyl group, a 4-methylcyclohexyl group, a 4-t-butylcyclohexyl group, an n-heptyl group, a 1-methylheptyl group, a 2,2-dimethylheptyl group, a 2-ethylheptyl group, a 2-butylheptyl group, an n-octyl group, t-octyl group, a 2-ethyloctyl group, a 2-butyloctyl group, a 2-hexyloctyl group, a 3,7-dimethyloctyl group, a cyclooctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, or the like, but the present disclosure is not limited thereto.

In the present description, the term "aryl group" means an optional functional group or substituent derived from an aromatic hydrocarbon ring. The aryl group may be a monocyclic aryl group or a polycyclic aryl group. The number of ring-forming carbon atoms in the aryl group may be 6 to 36, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, or the like, but the present disclosure is not limited thereto.

In the present description, the heteroaryl group may be a heteroaryl group including one or more of O, N, P, Si, or S as a heteroatom. The number of ring-forming carbon in the heteroaryl group may be 2 to 30 or 2 to 20. The heteroaryl group may be a monocyclic heteroaryl group or a polycyclic heteroaryl group. The polycyclic heteroaryl group may have, for example, a bicyclic structure or a tricyclic structure. Examples of the heteroaryl group may include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a quinolinyl group, a quinazolinyl group, a quinoxalinyl group, a phenoxazyl group, a phthalazinyl group, a pyrido pyrimidinyl group, a pyrido pyrazinyl group, a pyrazino pyrazinyl group, an isoquinolinyl group, indole group, a carbazole group, an N-arylcarbazole group, an N-heteroarylcarbazole group, an N-alkylcarbazole group, a benzoxazole group, a benzoimidazole group, a benzothiazole group, a benzocarbazole group, a benzothiophenyl group, a dibenzothiophenyl group, a thienothiophenyl group, a benzofuranyl group, a phenanthrolinyl group, a thiazolyl group, an isooxazolyl, an oxadiazolyl group, a thiadiazolyl group, a benzothiazolyl group, a phenothiazinyl group, a dibenzosilole group, a dibenzofuranyl group, or the like, but the present disclosure is not limited thereto.

In the description, the expression "being bonded to an adjacent group to form a ring" may refer to a state of being bonded to an adjacent group to form a substituted or unsubstituted hydrocarbon ring, or a substituted or unsubstituted heterocyclic ring. The hydrocarbon ring includes an aliphatic hydrocarbon ring and an aromatic hydrocarbon ring. The heterocyclic ring includes an aliphatic heterocyclic ring and an aromatic heterocyclic ring. The hydrocarbon ring and heterocyclic ring may be a monocyclic ring or a polycyclic ring. In some embodiments, the ring formed by being bonded to an adjacent group may be connected to another ring to form a spiro structure.

The substituted or unsubstituted alkyl group having 1 to 50 carbon atoms may include a urethane group, an amide group, an alkoxy group, etc.

In Formula 1, a and b are each independently an integer of 0 to 5. When a and b are 2 or more, R₉ and R₁₀ may each independently be bonded to adjacent groups to form a ring.

When the first luminescence material RM is a pyrene derivative, for example, the pyrene derivative may be represented by Formula 2:

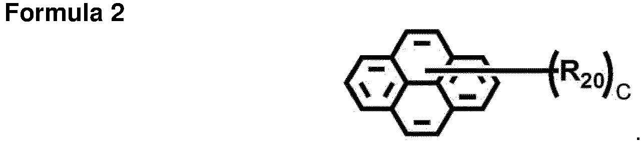

In Formula 2, R₂₀ is a hydrogen atom, a deuterium atom, a halogen atom, a substituted or unsubstituted silyl group, a substituted or unsubstituted alkyl group having 1 to 50 (*e.g.* 1 to 10) carbon atoms, a substituted or unsubstituted aryl group having 6 to 50 (*e.g.* 6 to 20) ring-forming carbon atoms, or a substituted or unsubstituted heteroaryl group having 2 to 50 (*e.g.* 2 to 20) ring-forming carbon atoms, or may be bonded to adjacent groups to form a ring.

c is 1 to 10. When c is 2 or more, the R₂₀ groups may be the same as or different from each other. At least one of the R₂₀ groups may not be (e.g., is not) hydrogen. The R₂₀ groups may include an amine group, for example, an arylamine group. The R₂₀ groups may be a substituted or unsubstituted arylene group.

In one embodiment, the luminescence auxiliary material may be at least one selected from a fluorescence material, a phosphorescence material, and a thermally activated delayed fluorescence (TADF) material.

For example, the luminescence auxiliary material may be a phosphorescence material or a thermally activated delayed fluorescence material. When the luminescence auxiliary material is a phosphorescence material or a thermally activated delayed fluorescence (TADF) material, intersystem crossing may occur, in which electrons excited to the lowest excited singlet energy level are transferred to the lowest triplet energy level (T₁^{R}) by receiving the first color light. Accordingly, energy may be transferred to the first luminescence material RM using all of the excited electrons, thereby achieving high-efficiency luminescence.

For example, the luminescence auxiliary material may be an organometallic complex configured to emit red light. The metal forming the organometallic complex may be selected from the group consisting of Ir, Pt, Os, Au, Cu, Re, and Ru. For example, the luminescence auxiliary material may be a porphyrin derivative. For example, the luminescence auxiliary material may be a porphyrin-metal complex.

Referring to FIG. 7B, in the display device DD according to an embodiment, the first light control part WCL1a may include a quantum dot QD1 as the first luminescence material RM. A core of the quantum dot may be selected from a Group II-VI compound, a Group III-V compound, a Group IV-VI compound, a Group IV element, a Group IV compound, and combinations thereof.

The Group II-VI compound may be selected from the group consisting of a binary element compound selected from the group consisting of CdSe, CdTe, ZnS, ZnSe, ZnTe, ZnO, HgS, HgSe, HgTe, MgSe, MgS, and combinations thereof; a ternary element compound selected from the group consisting of AglnS, CulnS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and combinations thereof; and a quaternary element compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and combinations thereof.

The Group III-V compound may be selected from the group consisting of a binary element compound selected from the group consisting of GaN, GaP, GaAs, GaSb, AlN, AlP, AlAs, AlSb, InN, InP, InAs, InSb, and combinations thereof; a ternary element compound selected from the group consisting of GaNP, GaNAs, GaNSb, GaPAs, GaPSb, AlNP, AlNAs, AlNSb, AlPAs, AlPSb, InGaP, InNP, InNAs, InNSb, InPAs, InPSb, and combinations thereof; and a quaternary element compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and combinations thereof.

The Group IV-VI compound may be selected from the group consisting of a binary element compound selected from the group consisting of SnS, SnSe, SnTe, PbS, PbSe, PbTe, and combinations thereof; a ternary element compound selected from the group consisting of SnSeS, SnSeTe, SnSTe, PbSeS, PbSeTe, PbSTe, SnPbS, SnPbSe, SnPbTe, and combinations thereof; and a quaternary element compound selected from the group consisting of SnPbSSe, SnPbSeTe, SnPbSTe, and combinations thereof. The Group IV element may be selected from the group consisting of Si, Ge, and combinations thereof. The Group IV compound may be a binary element compound selected from the group consisting of SiC, SiGe, and combinations thereof.

Here, the binary element compound, the ternary element compound, or the quaternary element compound may be present in a particle at a substantially uniform concentration, or may be present in the same particle in a state in which concentration distributions are partially different (e.g., a non-uniform distribution). For example, a core-shell structure may be possible in which one quantum dot QD1 surrounds another quantum dot QD1 (e.g., a first quantum dot material forms a shell around a second quantum dot material). The interface between the core and the shell may have a concentration gradient in which the concentration of elements present in the shell decreases toward the core.

In some embodiments, the quantum dot QD1 may have a core-shell structure including a core that contains the described nanocrystal, and a shell that surrounds the core. The shell of the quantum dot QD1 may serve as a protective layer for maintaining semiconductor characteristics by preventing or reducing chemical denaturation of the core and/or as a charging layer for giving electrophoresis characteristics to the quantum dot QD1. The shell may have a single layer or multi-layer. The interface between the core and the shell may have a concentration gradient in which the concentration of certain elements present in the shell decreases toward the core. The shell of the quantum dot QD1 may be, for example, a metal or nonmetal oxide, a semiconductor compound, or a combination thereof.

The metal or nonmetal oxide may be, for example, a binary element compound (such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO); or a ternary element compound (such as MgAl₂O₄, CoFe₂O₄, NiFe₂O₄, and/or CoMn₂O₄), but embodiments of the present disclosure are not limited thereto.

In some embodiments, the semiconductor compound may be, for example, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, or AlSb, but the present disclosure is not limited thereto.

The quantum dot QD1 may have a full width at half maximum (FWHM) of an emission wavelength spectrum of about 45 nm or shorter, about 40 nm or shorter, or about 30 nm or shorter, and the color purity or color reproducibility may be improved in the described range. For example, light emitted from such a quantum dot QD1 is emitted omnidirectionally, thereby improving the viewing angle of light.

Furthermore, the shape of the quantum dot QD1 is not particularly limited to those typically used in the art, and for example, a nanoparticle, nanotube, nanowire, nanofiber, nanoplanar particle, etc., having a spherical, pyramidal, multi-arm, or cubic form may be used. For example, the quantum dot QD1 may be a rod-shaped quantum rod. The color of light to be generated by the quantum dot QD1 may be adjusted according to its particle size, and accordingly, the quantum dot QD1 may have various emission colors such as blue, red, and green. The quantum dot QD1 may be to absorb light in the first wavelength range and subsequently to emit light in a shorter wavelength range according to the material and shape of the quantum dot QD1.

For example, when the core of the quantum dot QD1 includes a plurality of different compounds, the portions including different compounds in the core of the quantum dot QD1 may each have different band gap energies (difference between lowest conduction band energy level and highest valence band energy level). For example, the quantum dot QD1 may include a first portion composed of a first compound having a first band gap and a second portion composed of a second compound having a second band gap. Excitons excited to the lowest conduction band of the first band gap may fall to the highest valence band energy of the second band gap having a lower energy than the highest valence band energy of the first band gap. Accordingly, the quantum dot QD1 in an embodiment may be configured to absorb light in the first wavelength range and subsequently emit light in the shorter wavelength range (compared to the light in the first wavelength range).

The first light control part WCL1a may further include a base resin BR and a scattering particle SC in addition to the quantum dot QD1. The quantum dot QD1 and the scattering particle SC may be substantially uniformly or non-uniformly dispersed in the base resin BR. The scattering particle SC may scatter light emitted from the quantum dot QD1 to improve the viewing angle of light.

The base resin BR is a medium in which quantum dots QD1 and QD2 and/or scattering particles SC are dispersed, and may be formed of various resin compositions that may be generally referred to as binders. A polymer resin composition forming the base resin BR may include, for example, an acrylic-based resin, a urethane-based resin, a silicone-based resin, an epoxy-based resin, etc. The polymer resin composition may be transparent.

The scattering particles SC may be inorganic particles. For example, the scattering particles SC may include at least one selected from TiO₂, ZnO, Al₂O₃, SiO₂, and hollow silica. The scattering particles SC may include any one of TiO₂, ZnO, Al₂O₃, SiO₂, and hollow silica, or a mixture of two or more materials selected from TiO₂, ZnO, Al₂O₃, SiO₂, and hollow silica.

The second light control part WCL2 may transmit the first color light emitted from the luminescence element LD. For example, the second light control part WCL2 may be to transmit green light emitted from the luminescence element LD. The second light control part WCL2 may include a base resin BR and scattering particles SC. The second light control part WCL2 may not include a separate (additional) luminescence material. Accordingly, the density of the scattering particles SC in the second light control part WCL2 may be higher than the density of the scattering particles SC in the first light control part and the third light control part WCL3.

The third light control part WCL3 may include a second luminescence material to emit the third color light. The second luminescence material may be to absorb the first color light emitted from the luminescence element LD and to subsequently emit the third color light having a longer wavelength than the first color light. For example, the second luminescence material may be to absorb green light emitted from the luminescence element and to subsequently emit red light. The second luminescence material may be, for example, a quantum dot QD2. When the second luminescence material is a quantum dot QD2, the quantum dot QD2 may have substantially the same description or contents as the quantum dot QD1 described in the first luminescence material RM, except that the quantum dot QD2 may be to absorb light with a short (shorter) wavelength and emit light with a long (longer) wavelength.

In the display device DD according to an embodiment, the first light control part WCL1 (or WCL1a) may include a nanocrystal compound in addition to the organic compound or quantum dot. The nanocrystal compound may be a perovskite. The first to third light control parts WCL1, WCL2, and WCL3 may be to absorb the first color light to emit light having a shorter wavelength than the first color light. For example, the first light control part WCL1 may be to absorb the first color light to emit blue light, the second light control part WCL2 may be to absorb the first color light to emit green light, and the third light control part WCL3 may be to absorb the first color light to emit red light. The first color light may be infrared light. However, the embodiment is not limited to the description.

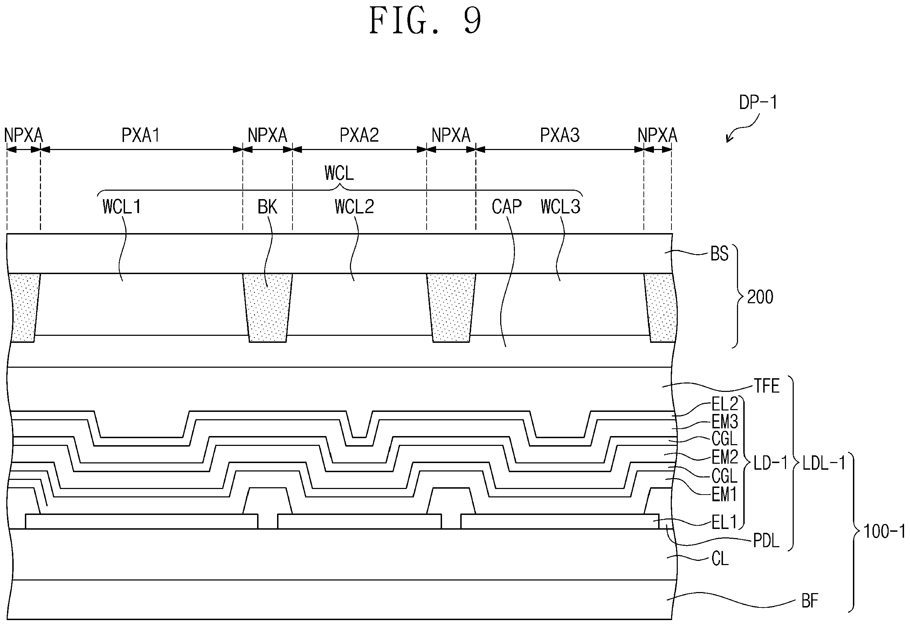

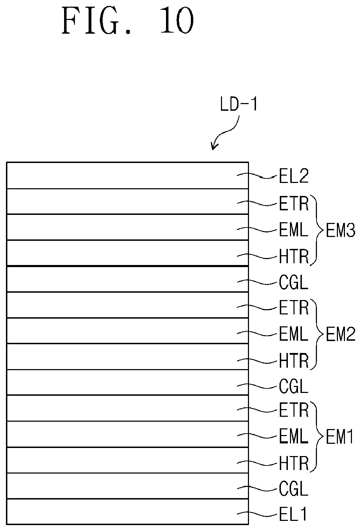

FIG. 9 is a cross-sectional view of the display panel DP-1 according to an embodiment. In FIG. 9, the display substrate 100-1 includes a luminescence element layer LDL-1 with a luminescence element LD-1. FIG. 10 is a cross-sectional view of the luminescence element LD-1 according to an embodiment. Referring to FIGS. 9 and 10, each of the luminescence elements LD-1 may include a plurality of emission parts EM1, EM2, and EM3. The plurality of emission parts EM1, EM2, and EM3 may be sequentially stacked and disposed. For the emission parts EM1, EM2, and EM3, substantially the same contents as the emission part EM described in FIG. 5, etc. may be applied. When a plurality of emission parts EM1, EM2, and EM3 are included, the higher luminance and longer life-time may be achieved than in the case of including one emission part EM.

Referring to FIG. 9, the display panel DP-1 according to an embodiment includes three stacked emission parts EM1, EM2, and EM3, but embodiments are not limited thereto. For example, two emission parts may be stacked, or four or more emission parts may be stacked. For example, three or four emission parts may be stacked. When five or more emission parts are stacked, the driving voltage of the luminescence elements LD-1 may be increased.

A charge generation layer CGL (e.g., a plurality thereof) may be disposed between the emission parts EM1, EM2, and EM3. When a voltage is applied to the charge generation layer CGL, a charge is generated. The charge generation layer CGL is disposed between the neighboring emission parts EM1, EM2, and EM3, and serves to control the charge balance between the emission parts EM1, EM2, and EM3. For example, the charge generation layer CGL between the emission parts EM1 and EM2 may serve to assist injection of electrons into the first emission part EM1 and assist injection of holes into the second emission part EM2.

The charge generation layer CGL may be composed of one layer in which an electron injecting material and a hole injecting material are mixed. In some embodiments, the charge generation layer CGL may be composed of two or more layers. For example, the charge generation layer CGL may include an n-type charge generation layer that is doped with an n-type dopant and a p-type charge generation layer that is doped with a p-type dopant. The n-type charge generation layer may be disposed directly or adjacent to the electron transport region ETR to assist injection of electrons, and the p-type charge generation layer may be disposed directly or adjacent to the bottom of the hole transport region HTR to assist injection of holes.

Materials of the charge generation layer CGL are not particularly limited, and any suitable materials available in the art may be used without limitation. On the other hand, in an embodiment, the charge generation layer CGL may be omitted.

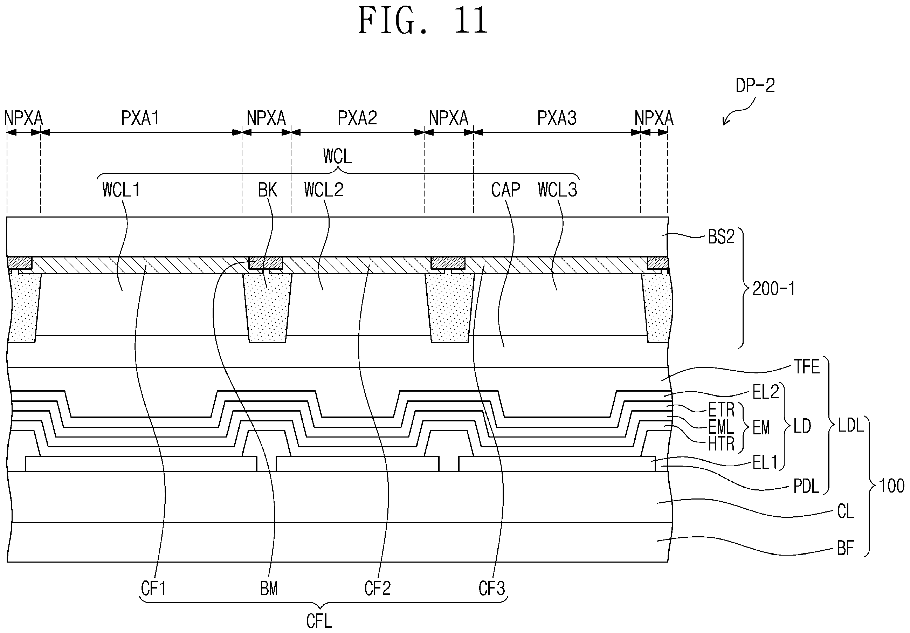

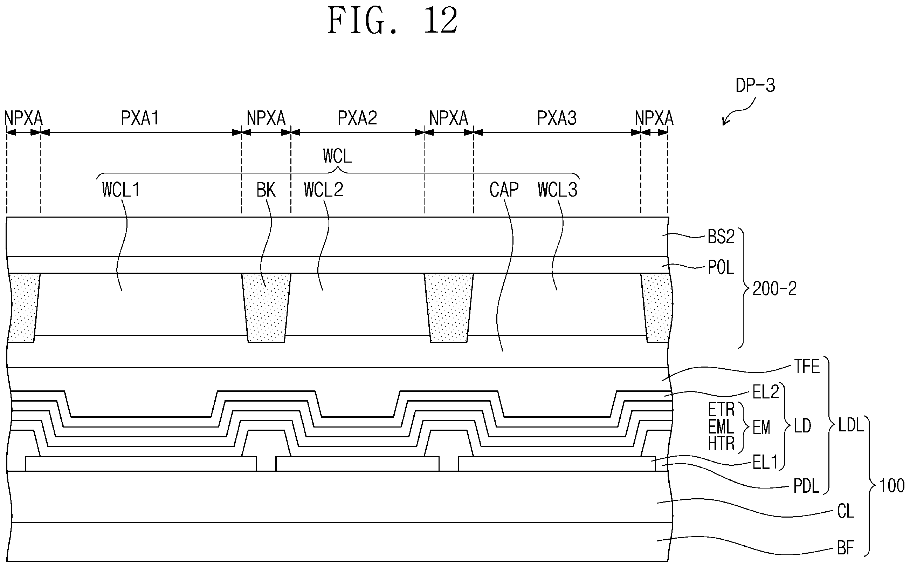

FIGS. 11 and 12 are cross-sectional views of the display panels DP-2 and DP-3 according to an embodiment, respectively. Referring to FIG. 11, the display panel DP-2 may further include a color filter layer CFL in the second display substrate 200-1. The color filter layer CFL may be disposed on the light control layer WCL. The color filter layer CFL may include a first color filter CF1, a second color filter CF2, and a third color filter CF3. The first to third color filters CF1, CF2, and CF3 may be disposed apart from each other. A light blocking layer BM may be disposed between the first to third color filters CF1, CF2, and CF3. The light blocking layer BM may be disposed directly below a second base layer BS2. The light blocking layer BM may overlap the non-emission area NPXA on a plane. The light blocking layer BM may include carbon black particles. The light blocking layer BM may prevent or reduce light emitted from the adjacent emission area from mixing. In an embodiment, the light blocking layer BM may be omitted.

The first color filter CF1 may overlap the first light control part WCL1, the second color filter CF2 may overlap the second light control part WCL2, and the third color filter CF3 may overlap the third light control part WCL3. Each of the first to third color filters CF1, CF2, and CF3 may be to transmit different wavelengths. For example, the first color filter CF1 may be to transmit the second color light and absorb the remaining light, the second color filter CF2 may be to transmit the first color light and absorb the remaining light, and the third color filter CF3 may be to transmit the third color light and absorb the remaining light.

Each of the first to third color filters CF1, CF2, and CF3 may be to transmit light emitted from the first to third light control parts WCL1, WCL2, and WCL3, respectively, and absorb the remaining light (e.g., light having a wavelength or color different from that desired to be emitted from the control layer). The first color filter CF1 may be a blue color filter to transmit blue light, the second color filter CF2 may be a green color filter to transmit green light, and the third color filter CF3 may be a red color filter to transmit red light.

The first to third color filters CF1, CF2, and CF3 may each independently include a base resin, and may each independently include at least one dye or pigment dispersed in the base resin. The first to third color filters CF1, CF2, and CF3 may include different kinds of dyes and pigments. For example, the first color filter CF1 may include at least one blue dye or blue pigment, the second color filter CF2 may include at least one green dye or green pigment, and the third color filter CF3 may include at least one red dye or red pigment.

The first to third color filters CF1, CF2, and CF3 are included in the above-described positions so that only the light in the target wavelength range is emitted from those positions, and the color reproducibility of the display panel DP-2 may be improved. For example, because reflection of external light may be reduced when the first to third color filters CF1, CF2, and CF3 absorb the light incident from the outside, the visibility of the display panel DP-2 may be improved.

Referring to FIG. 12, the display panel DP-3 according to an embodiment may further include a polarizing layer POL in the second display substrate 200-2. The polarizing layer POL may block or reduce some of the external light. The polarizing layer POL may perform an antireflection function to minimize or reduce reflection of external light. Accordingly, the visibility of the display panel DP-3 may be improved. The polarizing layer POL may include a circular polarizer or a linear polarizer, and a λ/4 phase retarder.

The display device DD according to an embodiment may include a luminescence element layer LDL to emit first color light and a light control layer WCL disposed on the luminescence element layer LDL. The light control layer WCL may include a first light control part WCL1 to emit second color light in a shorter wavelength range than the first color light, a second light control part WCL2 to transmit the first color light, and a third light control part WCL3 to emit third color light in a longer wavelength range than the first color light. For example, the display device DD according to an embodiment may include, on the luminescence element layer LDL serving as a light source, both (e.g., simultaneously) a first light control part WCL1 which is up-converted to a shorter-wavelength light than the light provided by the light source, and a third light control part WCL3 which is down-converted to a longer-wavelength light than the light provided by the light source. Accordingly, the display device DD according to an embodiment may effectively convert the light provided by the light source, and exhibit improved life-time characteristics and luminous efficiency characteristics. Therefore, the display device DD according to an embodiment may achieve long life-time and high efficiency.

A display device according to an embodiment of the present disclosure may achieve long life-time and high efficiency.

Although the example embodiments of the present disclosure have been described, it is understood that the present disclosure should not be limited to these example embodiments, but various changes and modifications can be made by one ordinary skilled in the art within the scope of the present disclosure as hereinafter claimed and equivalents thereof.

## Claims

1. A display device (DD) comprising:
a luminescence element layer (LDL); and
a light control layer (WCL) on the luminescence element layer (LDL),
wherein the light control layer (WCL) comprises:
a first light control part (WCL1) comprising a first luminescence material (RM) to emit a second color light in a shorter wavelength range than a first color light;
a second light control part (WCL2) to transmit the first color light; and
a third light control part (WCL3) comprising a second luminescence material to emit a third color light in a longer wavelength range than the first color light, and
the first to third light control parts (WCL1, WCL2, WCL3) are spaced apart from each other in a plan view.

2. A display device (DD) according to claim 1, wherein:
the first color light is green light having a center wavelength of 500 nm to 580 nm,
the second color light is blue light having a center wavelength of 420 nm to 480 nm, and
the third color light is red light having a central wavelength of 600 nm to 670 nm.

3. A display device (DD) according to claim 1 or claim 2, wherein the first light control part (WCL1) further comprises a luminescence auxiliary material.

4. A display device (DD) according to claim 3, wherein the luminescence auxiliary material is to absorb the first color light, to be excited, and to transfer energy to the first luminescence material (RM).

5. A display device (DD) according to claim 3 or claim 4, wherein a first lowest triplet energy level of the first luminescence material (RM) is greater than 1.2 eV and less than a second lowest triplet energy level of the luminescence auxiliary material, and
the second lowest triplet energy level is 2.5 eV or less.

6. A display device (DD) according to claim 5, wherein a lowest singlet energy level of the first luminescence material (RM) is 2.5 eV to 3.1 eV.

7. A display device (DD) according to claim 5, wherein the first luminescence material (RM) is a fluorescence material, and
the luminescence auxiliary material is a phosphorescence material or a thermally activated delayed fluorescence material.

8. A display device (DD) according to any one of claims 3 to 7,
wherein the first luminescence material (RM) is an anthracene derivative, and
the luminescence auxiliary material is a porphyrin-metal complex.

9. A display device (DD) according to any one of claims 1 to 7, wherein at least one of the first luminescence material (RM) and the second luminescence material is a quantum dot.

10. A display device (DD) according to any one of claims 1 to 9, wherein the display device (DD) further comprises a color filter layer (CFL) on the light control layer (WCL), wherein the color filter layer (CFL) comprises:
a first color filter (CF1) overlapping the first light control part (WCL1) to transmit the second color light;
a second color filter (CF2) overlapping the second light control part (WCL2) to transmit the first color light; and
a third color filter (CF3) overlapping the third light control part (WCL3) to transmit the third color light.

11. A display device (DD) according to any one of claims 1 to 10, wherein the luminescence element layer (LDL) comprises a luminescence element (LD),
the luminescence element (LD) comprises a first electrode (EL1), a second electrode (EL2), and at least one emission part (EM) between the first electrode (EL1) and the second electrode (EL2), and
the at least one emission part (EM) comprises:
a hole transport region (HTR);
an emission layer (EML) on the hole transport region (HTR); and
an electron transport region (ETR) on the emission layer (EML).

12. A display device (DD) according to claim 11, wherein the emission layer (EML) comprises a host and a dopant, and
the dopant comprises at least one selected from a phosphorescence dopant, a fluorescence dopant, and a thermally activated delayed fluorescence dopant

13. A display device (DD) according to claim 11, wherein the at least one emission part (EM) comprises a plurality of emission parts (EM1, EM2, EM3) sequentially stacked, and
the luminescence element (LD) further comprises a charge generation layer (CGL) between the plurality of emission parts (EM1, EM2, EM3).

14. A display device (DD) according to claims 1 to 13, wherein the first luminescence material (RM) is represented by Formula 1: 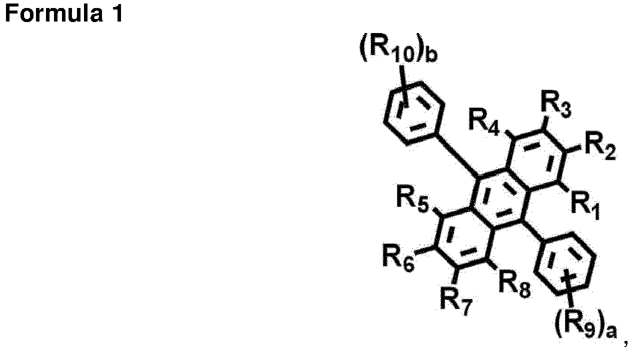 wherein in Formula 1,
R₁ to R₁₀ are each independently a hydrogen atom, a deuterium atom, a halogen atom, a substituted or unsubstituted silyl group, a substituted or unsubstituted alkyl group having 1 to 50 carbon atoms, a substituted or unsubstituted aryl group having 6 to 50 ring-forming carbon atoms, or a substituted or unsubstituted heteroaryl group having 2 to 50 ring-forming carbon atoms, or are bonded to adjacent groups to form a ring, and
a and b are each independently an integer of 0 to 5.
